# EUROPÄISCHE PATENTANMELDUNG

(11) **EP 2 308 948 A1**
(43) Veröffentlichungstag der Anmeldung: **13.04.2011**
(21) Anmeldenummer: 10186430.4
(22) Anmeldetag: 04.10.2010
(51) Int. Cl.: C09K 11/77, G21K 4/00

(54) **Szintillatormaterialien mit geringem Sauerstoffgehalt und Verfahren zur Herstellung derselben**

(30) Priorität: 09.10.2009 DE 102009045524
(71) Anmelder: Schott AG, 55122 Mainz (DE)
(72) Erfinder: von Saldern, Johann-Christoph, 07743 Jena (DE); Seitz, Christoph, 07745 Jena (DE); Parthier, Lutz, 14532 Kleinmachnowg (DE); Alkemper, Jochen, 55270 Klein-Winternheim (DE)
(74) Vertreter: Hrovat, Andrea Darinka

(57) **Zusammenfassung**

Die vorliegende Erfindung betrifft Szintillationsmaterialien mit definiertem Sauerstoffgehalt und Verfahren zu deren Herstellung. Insbesondere ist das Szintillationsmaterial der vorliegenden Erfindung durch dessen Herstellungsverfahren charakterisiert, so dass im Folgenden auch auf dieses Verfahren abgestellt wird, wenngleich die Erfindung ein Material als solches beansprucht. Die vorzugsweisen Sauerstoffgehalte können durch Zugabe von kohlenstoffhaltigen Verbindungen während der Herstellung des Materials erreicht werden.

## Beschreibung

Die vorliegende Erfindung betrifft Szintillationsmaterialien mit definiertem Sauerstoffgehalt und Verfahren zu deren Herstellung. Insbesondere ist das Szintillationsmaterial der vorliegenden Erfindung durch dessen Herstellungsverfahren charakterisiert, so dass im Folgenden auch auf dieses Verfahren abgestellt wird, wenngleich die Erfindung ein Material als solches beansprucht.

Die erfindungsgemäßen Szintillationsmaterialien weisen vorteilhafte Eigenschaften auf, insbesondere sind die Detektoreigenschaften der erfindungsgemäß hergestellten Szintillationsmaterialien verbessert.

Ferner weisen besondere Ausführungsformen der Erfindung auch eine vorteilhafte Spannungsdoppelbrechung (SDB) und eine hohe Homogenität der Brechzahl (HOM) auf.

Das erfindungsgemäße Verfahren ermöglicht auch die Herstellung von Szintillationsmaterialien, die neben den zuvor genannten positiven Eigenschaften auch noch eine besondere hohe mechanische Stabilität aufweisen. Besondere erfindungsgemäße Verfahren erlauben nämlich die Wahl an geeigneten Dotanden im Szintillationsmaterial. Solche Materialien stellen ganz besondere Ausführungsformen der Erfindung dar.

Szintillationsmaterialien auf Halogenidbasis gemäß dem Stand der Technik weisen den Nachteil auf, dass während der Herstellung Wasser und Sauerstoff, entweder aus den verarbeiteten Rohstoffen oder aus der Umwelt, Oxihalogenidverbindungen in der Schmelze ausbilden, was während der Kristallisation ursächlich für Spannungen im Material ist. Diese unerwünschten Spannungen sind auf Ausscheidungen während des Kristallisationsprozesses zurückzuführen und beeinflussen die mechanischen Eigenschaften des Materials erheblich negativ. Insbesondere neigen die Szintillationsmaterialien gemäß dem Stand der Technik zum Brechen. Ferner ist ein entscheidender Parameter, nämlich die Lichtausbeute, der sogenannte "Light Yield", des Materials vermindert.

Ferner führen bekannte Herstellungsverfahren zu geringen Ausbeuten.

Szintillationsmaterialien gemäß dem Stand der Technik oder Szintillationsmaterialien, die herkömmlicherweise hergestellt werden, weisen zudem eine schlechte Bearbeitbarkeit auf, eben bedingt durch die erhöhte Neigung zum Brechen. Bruchempfindlichkeit kann durch Inhomogenitäten im Material, durch thermische Verspannungen und auch durch Kristalldefekte hervorgerufen werden. Sofern thermische Verspannungen auftreten, kann dies zu einer erheblichen Spannungsdoppelbrechung des Szintillationsmaterials führen und ferner zu Inhomogenitäten der Brechzahl. Auf herkömmliche Weise hergestellte Szintillationsmaterialien weisen folglich teilweise erhebliche Unterschiede, sowohl was die Lichtausbeute, die mechanischen Eigenschaften als auch was ein Verhalten bei der Nacharbeitung angeht, auf. Dies ist insbesondere auffällig für einkristalline Materialien, die sich von Kristall zu Kristall unterschiedlich verhalten. Ein zu hoher Sauerstoffgehalt im Material beeinflusst wesentliche Eigenschaften negativ.

Mit Blick auf die Nachbearbeitung, wie Trennen, Schleifen und Polieren, ist ein erheblicher Aufwand zu betreiben, sofern die Materialien herkömmlicherweise hergestellt werden, was zu dem schon zuvor als nachteilig genannten erheblichen Ausschuss führt.

Erhebliche Unterscheide bzgl. der Szintillationseigenschaften von Kristall zu Kristall sind jedenfalls auch als nachteilig zu bewerten.

Die Materialien und Verfahren gemäß der vorliegenden Erfindung beschränken sich nicht auf einkristalline Szintillationsmaterialien und deren Herstellung, wenngleich dies besondere Ausführungsformen darstellen. Vielmehr können erfindungsgemäß auch polykristalline Materialien hergestellt und bereit gestellt werden. Solche polykristallinen Gebilde sind bevorzugter Weise im Wesentlichen ohne Zwischenräume/Korngrenzen, was annähernd zu Eigenschaften führt, die einem Einkristall entsprechen.

Bevorzugt sind Verfahren zur Herstellung einkristalliner Szintillationsmaterialien, da die erfindungsgemäßen Verfahren geeignet sind, Einkristalle in vorzugsweiser Größe herzustellen. Sofern das Material polykristallin ist, sollten die einzelnen Kristallite dergestalt ausgerichtet sein, dass ein möglichst isotropes Verhalten des jeweiligen Materials resultiert.

Aus dem Stand der Technik sind beispielsweise Szintillationsmaterialien auf der Basis von Cerbromid bekannt, siehe beispielsweise US 7,405,404 B1. Das hier diskutierte Cerbromid kann auch dotiert sein. Insbesondere Yttrium, Hafnium, Zirkonium Palladium und Bismut sind als Dotanden nicht erwähnt. Ferner sind die Verfahren zur Herstellung der einkristallinen Szintillationsmaterialien gängige, dem Fachmann bekannte Verfahren. Besondere Bedingungen der Atmosphäre während der Kristallzucht sind nicht erwähnt. Gleiches gilt für Abkühlbedingungen oder Abkühlraten während des Herstellungsverfahrens.

EP 1 930 395 A2 beschreibt Szintillatorzusammensetzungen, die aus unterschiedlichen "Vor-Szintillatorzusammensetzungen" hergestellt werden. Über die Atmosphäre bei einer Kristallzucht wird nichts ausgeführt. Temperregime oder Abkühlraten werden ebenfalls nicht genannt.

US 2008/0067391 A1 offenbart unter Anderem einkristalline Szintillationen einer bestimmten Formel. Es geht hierbei um Dotanden in dem Material und nicht um ein bestimmtes Herstellungsverfahren, das einen verminderten Sauerstoffgehalt in dem Material bedingen könnte.

Es besteht demnach ein großer Bedarf an Szintillationsmaterialien mit Sauerstoffgehalten von kleiner als 2.500 ppm und an neuen Herstellungsverfahren für Szintillationsmaterialien, die diesen geringen Sauerstoffgehalt im fertigen Material aufweisen. Dieser Gehalt sollte kleiner als 2.500 ppm, vorzugsweise kleiner als 1.000 ppm und weiter bevorzugt kleiner als 500 ppm.

Dabei soll das Verfahren flexibel einsetzbar sein, was sowohl das Herstellen einkristalliner als auch polykristalliner Materialien möglich machen soll.

Weiter bevorzugt soll ein Verfahren bereitgestellt werden, das ermöglicht, große Einkristalle hervorzubringen, sofern einkristalline Materialien gewünscht sind. Eine weitere Anforderung an das Verfahren ist eine möglichst hohe Ausbeute an Material bei gleichzeitig einfacher Handhabung. Die nach dem Verfahren hergestellten Materialien sollen ferner die oben beschriebenen vorteilhaften Eigenschaften aufweisen, nämlich einen geringen Sauerstoffgehalt im Material von kleiner als 2.500 ppm, vorzugsweise kleiner als 1.000 ppm und weiter bevorzugt von kleiner als 500 ppm.

Die Materialien sollen eine gute Festigkeit aufweisen und das Verfahren soll dementsprechend das Kriterium erfüllen, Materialien mit guter mechanischer Festigkeit und entsprechender guter Nachbearbeitbarkeit hervorzubringen.

Das Verfahren soll ferner flexibel einsetzbar sein zur Herstellung von Szintillationsmaterialien auf Basis von Halogeniden von Seltenen Erden, beispielsweise Lanthanhalogeniden, insbesondere Cerbromid, wobei diese Substanzen wahlweise auch dotiert sein können.

Gelöst werden die oben genannten Aufgaben der vorliegenden Erfindung durch ein Material und Verfahren wie in den Patentansprüchen beschrieben.

### Die Erfindung betrifft insbesondere ein

Verfahren zur Herstellung eines Szintillationsmaterials mit einem Sauerstoffgehalt von kleiner als 2.500 ppm, vorzugsweise kleiner als 1.000 ppm und weiter bevorzugt von kleiner als 500 ppm im Material, umfassend eine Verbindung der allgemeinen Summenformel LnX₃ oder LnX₃:D, wobei Ln ausgewählt ist aus mindestens einem von Sc, Y, La, Ce, Pr, Nd, Pm, Sm, Eu, Gd, Tb, Dy, Ho, Er, Tm, Yb, Lu und X ausgewählt ist aus F, Cl, Br und I, und D ein kationischer Dotand, ausgewählt aus einem oder mehreren der Elemente Y, Zr, Hf, Pd und Bi ist, und, sofern vorhanden, in einer Menge von 10 ppm bis 10.000 ppm im Material vorliegt, umfassend:
Wahlweise Mischen von LnX₃ mit mindestens einem der Dotanden D;
Erwärmen bis zum Schmelzpunkt des Gemisches, dadurch gekennzeichnet, dass
kohlenstoffhaltige Gase der Züchtungsatmosphäre beigesetzt werden.

Geeignete kohlenstoffhaltige Gase sind vorzugsweise Kohlenstoffhalogenide, wie CCl₄, CBr₄, CJ₄ und andere. Je nach Züchtungsbedingungen, insbesondere Druck und Temperatur, reagieren diese Gase mit dem Sauerstoff in der Züchtungsatmosphäre, wobei sich Carbonoxihalogenide bilden, welche sich in der Gasatmosphäre anreichern und nicht in den Kristall eingebaut werden. Gemäß diesem erfindungsgemäßen Verfahren ist der entsprechende Kristall nahezu frei von Sauerstoff, wie zuvor beschrieben beträgt der Gehalt an Sauerstoff kleiner als 2.500 ppm.

Dabei ist die Befüllung mit den kohlenstoffhaltingen Gase zu wählen, dass der Gesamtdruck in der Ampulle bei der Züchtungstemperatur 1000 hPa nicht übersteig, wohl aber größer ist als der höchste Partialdruck einer Züchtungskomponente.

Neben der erfindungsgemäß entscheidenden Atmosphäre während der Kristallzucht können wahlweise und ja nach herzustellendem Material noch weitere Bedingungen während dem Verfahren gewählt werden. So kann beispielsweise das Gemisch von der Züchtungstemperatur bis zu 100°C mit einer Abkühlrate von kleiner als 20K/h abgekühlt werden. Ferner kann das Gemisch in dem Temperaturbereich von 100°C bis 25°C mit einer Abkühlrate von weniger als 40K/h abgekühlt werden, wobei der maximale Temperaturgradient im Kristall weniger als 10K/cm betragen sollte.

Gemäß einer besonderen Ausführungsform umfasst das Verfahren weiterhin die folgenden Schritte:
- Einbringen eines Lanthanhalogenids, wahlweise mit oder ohne Dotand, in eine geeignete Ampulle;
- Evakuierung der Ampulle;
- Begasen der Ampulle mit einem Kohlenstoffhalogenid und wahlweise zusätzlich mit einem Inertgas;
- Wahlweise Abschmelzen der Ampulle;
- Erwärmen der Ampulle und anschließendes Züchten eines Kristalls oder eines kristallinen Gefüges,
- Wahlweise Abkühlen mit einer Rate von kleiner oder gleich 20K/h,
- Wahlweise entsprechendes Abkühlen mit der zuvor genannten Rate von der Züchtungstemperatur bis zu einer Temperatur von etwa 100°C,
- Abkühlen in einem Temperaturbereich von etwa 100°C bis 20°C mit beispielsweise weniger als 40K/h.

Vorzugsweise beträgt der maximale Temperaturgradient im Kristall, sofern es sich um einkristallines Material handelt, weniger als 10K/cm. Gemäß besonders bevorzugten Ausführungsformen ist dieser Temperaturgradient weniger als 5K/cm und am meisten bevorzugt weniger als 2K/cm bei gleichzeitig erfindungsgemäß niedrigem Sauerstoffgehalt.

Die Abkühlrate innerhalb des Temperaturbereiches, der von der Züchtungstemperatur aus bis etwa 100°C reicht, ist gemäß bevorzugten Ausführungsformen des Verfahrens unterhalb 10K/h und am meisten bevorzugt etwa 5K/h.

Was die weitere Abkühlrate in dem Temperaturbereich ausgehend von etwa 100°C bis 25°C betrifft, so ist eine Abkühlrate 20K/h und weiter bevorzugt von 10K/h möglich.

Das erfindungsgemäße Verfahren ist universell einsetzbar zur Herstellung von Szintillationsmaterialien mit Sauerstoffgehalten von kleiner oder gleich 2.500 ppm umfassend ein Material der Formel LnX₃, wobei Ln ausgewählt ist aus Sc, Y, La, Ce, Pr, Nd, Pm, Sm, Eu, Gd, Tb, Dy, Ho, Er, Tm, Yb, Lu und X ausgewählt aus F, Cl, Br und I. Ebenso herstellbar sind Materialien umfassend LnX₃:D, wobei für Ln und X die zuvor genannten Definitionen gelten und D ein kationischer Dotand, ausgewählt aus einem oder mehreren der Elemente Y, Zr, Hf, Pd und Bi ist, und in einer Menge von 10 ppm bis 10.000 ppm im Material vorliegt.

Vorzugsweise werden erfindungsgemäß Szintillationsmaterialien hergestellt, die aus der zuvor genannten Verbindung LnX₃ oder LnX₃:D bestehen und die niedrigen Sauerstoffgehalte aufweisen.

Sofern aus dem erfindungsgemäßen Verfahren Materialien hervorgehen, die dotiert sind, kann der Dotand in einer Menge von 50 ppm bis 5.000 ppm im Material vorliegen, vorzugsweise in einer Menge von 100 ppm bis 10.000 ppm.

Erfindungsgemäß bevorzugt wird reines Cerbromid gemäß dem hier beschriebenen Verfahren hergestellt. Ferner bevorzugt sind auch Materialien, für die das Kation Lanthan, Lutetium und Praseodym ist. Bevorzugte Anionen sind Chlor, Brom und Iod, mit Chlor und Brom als weiter bevorzugte Anionen.

Die wahlweise einsetzbaren Abkühlraten können umgesetzt werden gemäß dem Fachmann an sich bekannten Verfahren zur Herstellung von Einkristallen, wie beispielsweise das Bridgman oder Czochralski-Verfahren. In üblicher Weise werden Ausgangshalogenide, mit oder ohne Dotanden, zur Schmelze erwärmt und dann erfindungsgemäß zur Kristallisation abgekühlt.

Die erfindungsgemäß erhaltenen Materialien zeichnen sich unter anderem durch eine exzellente Lichtausbeute aus. Die Abklingzeit der Szintillationsmaterialien verkürzt sich, was die Reaktionszeit verkürzt.

Für den Fall einkristalliner Materialien ist es möglich, großvolumige Einheiten mit größer als 5 cm³ herzustellen, die die erfindungsgemäß gewünschten niedrigen Sauerstoffgehalte aufweisen. Bevorzugterweise weisen die Materialien ferner eine niedrige Spannungsdoppelbrechung und eine hervorragenden Homogenitäten der Brechzahl auf.

Sofern die Materialien dotiert sind, liegt der Dotand oder liegen die Dotanden in Mengen von 50 ppm bis 10.000, 100 bis 5.000 ppm, weiter bevorzugt in Mengen von 100 ppm bis 1.000 ppm im Szintillationsmaterial vor.

Aufgrund des unterschiedlichen Ionenradius der Dotanden D zu den Kationen der Gruppe Ln werden lokale Spannungen im Wirtskristall hervorgerufen. Bislang wurde angenommen, dass solche lokalen Spannungen nachteilig sind. Überraschenderweise konnte jedoch nun gefunden werden, dass diese die Gitterenergie erhöhen und zwar in dem Maße, dass die kritische Energie zur Rissbildung bzw. zur Fortschreitung von Rissen deutliche erhöht wird.

Beim Züchtungsprozess führen diese lokalen Spannungen zu weniger Kristallbaufehlern. Die durch den zur Zucht nötigen Gradienten erzeugten thermischen Spannungen werden nicht durch Defekte abgebaut (kein plastischer sondern elastischer Spannungsabbau). Dies führt zum einen zu einer geringeren thermischen Verspannung des Kristalls.

Ferner führt die geringere Defektkonzentration zu einer Verringerung der nicht strahlenden Übergänge und damit zu einer Erhöhung der Lichtausbeute, des Light Yields, insbesondere ohne dabei die anderen Szintillationseigenschaften, wie die Abklingzeit und die Energieauflösung, negativ zu beeinflussen. Es kann ein Dotand D in einer Menge von 500 ppm bis 5.000 ppm im erfindungsgemäß hergestellten Szintillationsmaterial vorliegen. Besonders bevorzugt ist ein Gehalt von 100 ppm, bevorzugt größer als 500 ppm bis zur Obergrenze von 1.000 ppm.

Es hat sich herausgestellt, dass das erfindungsgemäß hergestellte Szintillationsmaterial besonders vorteilhafte Eigenschaften aufweist wenn das Element Ln, das kationisch vorliegt, ausgewählt ist aus La, Ce, Lu, Pr und Eu. Vorzugsweise ist Ln ausgewählt aus La und Ce.

Das Anion X ist besonders bevorzugt ausgewählt aus Cl, Br und I, weiter bevorzugt ausgewählt aus Cl und Br. Am meisten bevorzugt ist das erfindungsgemäße Szintillationsmaterial dotiertes CeBr₃.

Auch bevorzugt gemäß der vorliegenden Erfindung wird dotiertes Lutetiumiodid und ebenso dotiertes Lanthanbromid hergestellt.

Szintillationsmaterialien der oben beschriebenen Zusammensetzungen mit den erfindungsgemäßen Dotanden hergestellt nach der Erfindung zeichnen sich durch eine ausgesprochen gute Härte auch bei Temperaturen nahe ihrem Schmelzpunkt aus. In der Folge werden weniger Kristalldefekte erzeugt und weniger Spannungen generiert.

Bei der Durchführung des erfindungsgemäßen Verfahrens kann beim Tempern ein homogenes Temperaturfeld mit einer Temperatur von maximal 10 K, bevorzugt 50 K und am meisten 100 K unterhalb der Schmelztemperatur des Materials eingesetzt werden. Der Temperaturgradient ist dabei kleiner 2 K/cm, bevorzugt kleiner 1 K/cm und am meisten bevorzugt kleiner 0,5 K/cm. Die Aufheiz- und Abkühlraten sind im Temperschritt wie beim Abkühlprozess zu wählen.

Das so erhaltene Szintillationsmaterial zeichnet sich nicht nur durch den niedrigen Sauerstoffgehalt sondern auch durch eine Spannungsdoppelbrechung von kleiner als 1 µm/cm, bevorzugt kleiner 50 nm/cm und am meisten kleiner 10 nm/cm aus. Neben der Spannungsdoppelbrechung wird durch eine geeignete Temperung auch die Brechzahlhomogenität deutlich verbessert. Damit sind PV-Werte von besser als Δn =10⁻³ zu erzielen. Unter dem PV-Wert versteht der Fachmann den maximal auftretenden Unterschied der Brechzahlen. PV steht als Abkürzung für "peak to valley".

Erfindungsgemäß beträgt die Hintergrundstrahlung des Szintillationsmaterials bevorzugterweise weniger als 0,5 Bq/cm³, was durch die hohe Reinheit des Materials ermöglicht wird. Verunreinigungen, die zu radioaktive Hintergrundstrahlung beitragen, werden auch Wahl entsprechend reiner Ausgangsverbindungen vermieden.

### Beispiel 1

Zur Herstellung eines erfindungsgemäßen Materials werden in eine Ampulle aus Quarzglas mit einem Innendurchmesser von 30 mm in einer mit Argon gefüllten "Glovebox", wobei Wasser und Sauerstoff zu weniger als 5 ppm in der Atmosphäre vorliegen, 500 g Cerbromid und 0,5 g CBr₄ eingewogen. Die Ampulle wurde anschließend evakuiert und mit 50 mbar Argon befüllt und abgeschmolzen. An der Spitze der Ampulle befindet sich eine 30 mm lange Kapillare mit einem Innendurchmesser von 3 mm. Die Ampulle wurde in einen 3 Zonen Bridgman Ofen verbracht. Zunächst wurde die Temperatur 48 Stunden lang bei 780°C gehalten. Anschließend wurde mit einer Absenkrate von 1 mm/h ein Kristall gezüchtet. Der Kristall wird sodann abgekühlt. Von der Züchtungstemperatur bis zu einer Temperatur von 100°C mit einer Abkühlrate von kleiner als 10K/h. Danach wird die Abkühlrate auf kleiner 20K/h bis zum Erreichen der Raumtemperatur justiert. Während der gesamten Zucht war der Temperaturgradient im Kristall kleiner als 5K/cm.

Die Ampulle wurde dann in der Glovebox geöffnet und der Kristall entnommen.

### Beispiel 2

Zur Herstellung eines erfindungsgemäßen Materials werden in eine Ampulle aus Quarzglas mit einem Innendurchmesser von 30 mm in einer mit Argon gefüllte "Glovebox", wobei Wasser und Sauerstoff zu weniger als 5 ppm in der Atmosphäre vorliegen, 500 g Cerbromid, 0,26 g BiBr₃ (entsprechend 0,125 g Bismut) und 0,29 g HfBr₃ (entsprechend 0,125 g Hafnium) und 0,5 g CBr₄ eingewogen. Die Ampulle wurde anschließend evakuiert und mit 50 mbar Argon befüllt und abgeschmolzen. An der Spitze der Ampulle befindet sich eine 30 mm lange Kapillare mit einem Innendurchmesser von 3 mm. Die Ampulle wurde in einen 3 Zonen Bridgman Ofen verbracht. Zunächst wurde die Temperatur 48 Stunden lang bei 780°C gehalten. Anschließend wurde mit einer Absenkrate von 1 mm/h ein Kristall gezüchtet. Der Kristall wird sodann abgekühlt. Von der Züchtungstemperatur bis zu einer Temperatur von 100°C mit einer Abkühlrate von kleiner als 10K/h. Danach wird die Abkühlrate auf kleiner 20K/h bis zum Erreichen der Raumtemperatur justiert. Während der gesamten Zucht war der Temperaturgradient im Kristall kleiner als 5K/cm.

Die Ampulle wurde dann in der Glovebox geöffnet und der Kristall entnommen

## Patentansprüche

1. Szintillationsmaterial mit einem Sauerstoffgehalt von maximal 2.500 ppm im Material, umfassend eine Verbindung der allgemeinen Summenformel LnX₃ oder LnX₃:D, wobei Ln ausgewählt ist aus mindestens einem von Sc, Y, La, Ce, Pr, Nd, Pm, Sm, Eu, Gd, Tb, Dy, Ho, Er, Tm, Yb, Lu und X ausgewählt ist aus F, Cl, Br und I, und D ein kationischer Dotand, ausgewählt aus einem oder mehreren der Elemente Y, Zr, Hf, Pd und Bi ist, und, sofern vorhanden, in einer Menge von 10 ppm bis 10.000 ppm im Material vorliegt, hergestellt durch
- wahlweise Mischen von LnX₃ mit mindestens einem der Dotanden D;
- Zugabe mindestens einer kohlenstoffhaltigen Verbindung
- Erwärmen des Gemisches bis zum Schmelzpunkt und
- Abkühlen der Schmelze zum Erhalt eines Einkristalls oder polykristallinen Gefüges nach bekannten Verfahren.

2. Szintillationsmaterial nach Anspruch 1, wobei der Sauerstoffgehalt im Material maximal 1.000 ppm beträgt.

3. Szintillationsmaterial nach Anspruch 1 oder 2, wobei das Material aus einem Material der zuvor genannten Summenformel besteht.

4. Verfahren zur Herstellung eines Szintillationsmaterials mit einem Sauerstoffgehalt von maximal 2.500 ppm im Material, umfassend eine Verbindung der allgemeinen Summenformel LnX₃ oder LnX₃:D, wobei Ln ausgewählt ist aus mindestens einem von Sc, Y, La, Ce, Pr, Nd, Pm, Sm, Eu, Gd, Tb, Dy, Ho, Er, Tm, Yb, Lu und X ausgewählt ist aus F, Cl, Br und I, und D ein kationischer Dotand, ausgewählt aus einem oder mehreren der Elemente Zr, Hf und Bi ist, und, sofern vorhanden, in einer Menge von 10 ppm bis 10.000 ppm im Material vorliegt, umfassend:
- wahlweise Mischen von LnX₃ mit mindestens einem der Dotanden D
- Zugabe mindestens einer kohlenstoffhaltigen Verbindung
- Erwärmen des Gemisches bis zum Schmelzpunkt und
- Abkühlen der Schmelze zum Erhalt eines Einkristalls oder polykristallinen Gefüges nach bekannten Verfahren.

5. Verfahren nach Anspruch 4, wobei die kohlenstoffhaltige Verbindung ein Kohlenstoffhalogenid ist.

6. Verfahren nach Anspruch 5, wobei die Kohlenstoffhalogenide ausgewählt sind aus einem oder mehreren von CCl₄ CBr₄, CJ₄.

7. Verfahren nach einem oder mehreren der vorangegangenen Ansprüche, wobei zusätzlich das Gemisch von der Züchtungstemperatur bis zu 100°C mit einer Abkühlrate von kleiner als 20K/h abgekühlt wird und das Gemisch ferner in dem Temperaturbereich von 100°C bis 25°C mit einer Abkühlrate von weniger als 40K/h abgekühlt wird.

8. Verfahren nach einem oder mehreren der vorangegangenen Ansprüche, wobei die Abkühlrate im Bereich der Züchtungstemperatur bis 100°C 10K/h und kleiner beträgt.

9. Verfahren nach einem der vorhergehenden Ansprüche, wobei die Abkühlrate im Temperaturbereich von 100°C bis 25°C 40K/h oder weniger beträgt.

10. Verfahren nach Anspruch 9, wobei die Abkühlrate im Temperaturbereich von 100°C bis 25°C 20K/h oder weniger beträgt.

11. Verfahren nach Anspruch 10, wobei die Abkühlrate im Temperaturbereich von 100°C bis 25°C 10K/h oder weniger beträgt.
